# EUROPEAN PATENT APPLICATION

(11) **EP 2 116 902 A1**
(43) Date of publication of application: **11.11.2009**
(21) Application number: 08710841.1
(22) Date of filing: 06.02.2008
(51) Int. Cl.: G03F 7/32, G03F 7/004, G03F 7/027, G03F 7/40

(54) **COMPOSITION FOR FORMING CURED FILM PATTERN, AND METHOD FOR PRODUCING CURED FILM PATTERN BY USING THE SAME**

(30) Priority: 16.02.2007 JP 2007036764
(71) Applicant: Taiyo Ink MFG. CO., LTD., Tokyo 176-8508 (JP)
(72) Inventor: KAKUTANI, Takenori, Hiki-gun Saitama 355-0222 (JP); MIYABE, Hidekazu, Hiki-gun Saitama 355-0222 (JP)
(74) Representative: HOFFMANN EITLE
(86) International application number: PCT/JP2008/051944
(87) International publication number: WO 2008/099732

(57) **Abstract**

A composition for forming a cured film pattern comprises a combination of: an alkaline developable photocurable and thermosetting composition containing no thermal curing catalyst; and a developing solution comprising an aqueous solution of a basic curing catalyst of a nitrogen-containing heterocyclic compound for promoting a thermosetting reaction so that it has a long pot-life (useful life) after mixing of a main agent and a hardener or has excellent storage stability as a one-package composition. Preferably, the basic curing catalyst is a heterocyclic compound having an amidine structure. A film of the photocurable and thermosetting composition is selectively exposed to an actinic energy ray and then developed with the developing solution to remove an unexposed area of the film. At this time, the basic curing catalyst penetrates into the photocured film to effect doping. As a result, the film becomes excellent in thermosetting properties besides the patterning properties by development.

## Description

### Technical Field

This invention relates to a composition for forming a cured film pattern and a method of producing a cured film pattern by the use thereof, which allows preparation of a photocurable and thermosetting composition which is used for the formation of a solder resist, an interlaminar insulating layer, or the like for a printed circuit board, has a long pot-life (useful life) after mixing of a main agent and a hardener or has excellent storage stability as a one-package composition and is capable of forming a cured film pattern excelling in various properties such as fastness of adhesion to various substrates, resistance to heat, resistance to humidity, resistance to chemicals, resistance to electroless gold plating, electrical insulating properties, and flexibility.

### Background Art

At present, the compositions which utilize both the photo-curing and the thermosetting (dual cure), including a solder resist to be used as a permanent protective film of a printed circuit board, are widely used in the field of electronics which requires high density, high resolution, and high reliability. These compositions are generally composed of a resin containing an epoxy acrylate having a carboxyl group introduced thereinto for imparting photosensitivity and developability with a dilute aqueous alkali solution thereto and a thermosetting component, such as an epoxy resin, for improving the film characteristics after formation of a desired film pattern according to a photolithographic process. For instance, JP 61-243869,A (patent literature 1) discloses a solder resist composition comprising a photosensitive resin obtained by addition of an acid anhydride to the reaction product of a novolak type epoxy compound with an unsaturated monobasic acid, a photopolymerization initiator, a diluent, and an epoxy compound. When this composition is used, by thermally curing the composition after formation of a pattern, the addition reaction of a carboxyl group and an epoxy group which remain in a coating film takes place to form the three-dimensional network structure, thereby giving rise to a cured film excelling in such properties as fastness of adhesion, hardness, resistance to heat, and electrical insulating properties. In this case, a curing catalyst or curing promotor for epoxy resins is usually used together with an epoxy resin. Although a variety of compounds are conventionally known as this curing promotor for epoxy resins, dicyandiamide (cyanoguanidine) and melamine are also mentioned as its example.

When dicyandiamide or melamine is incorporated into the alkaline developable photocurable and thermosetting composition as mentioned above together with an epoxy resin, however, there are many operational problems such as inducing defective development because of the short useful life due to the gradual reaction of the carboxyl group contained in the photosensitive resin with the epoxy group of the epoxy compound during the interval between the drying step and the developing step. Accordingly, these photocurable and thermosetting compositions are usually formulated as the two-package type composed of a main agent containing a carboxylic group-containing photosensitive resin and a hardener containing an epoxy compound. They do not fully manifest their characteristics unless they are put to use after the main agent and the hardener have been thoroughly mixed.

As a trial for acquiring long useful life (long pot life), for example, JP 8-335768,A (patent literature 2) proposes a one-package type solder resist composition comprising a carboxyl group-containing photosensitive prepolymer, a diluent, a photopolymerization initiator, and melamine or its derivative, or further 2, 4, 6-trimercapto-s-triazine, and JP 8-335767,A (patent literature 3) proposes a one-package type solder resist composition comprising a carboxyl group-containing photosensitive prepolymer, a diluent, a photopolymerization initiator, and a vinyltriazine compound or its derivative. Both of these compositions are trying to eliminate an epoxy resin which is a thermosetting component from the composition, to form a cured film owing to the radical polymerization of unsaturated double bonds, and to acquire adhesiveness by the chelating effect of the above-mentioned compounds which exhibit the basic nature to a copper substrate. These compositions, however, fail to acquire sufficient characteristics such as resistance to heat and resistance to electroless gold plating like the two-package type composition containing a usual thermosetting component exhibits. Therefore, in case of a composition containing a thermosetting component which is thermally cured to certainly form the three-dimensional network structure, it is possible only with difficulty to formulate a composition of which useful life is long and which excels in storage stability. Accordingly, the composition exhibiting such contrary characteristics hardly exists.

Further, for the purpose of stabilizing the epoxy-based composition as a one-package composition, some of the catalysts which exhibit the thermal potentiality have been heretofore proposed as a catalyst which promotes the thermal reaction of a thermosetting resin such as an epoxy resin (hereinafter referred to as a thermal curing catalyst). For example, an amine-imide compound which is activated by thermal decomposition, a ketimine compound which is activated by contact with moisture, and a thermal curing catalyst encapsulated in the form of a microcapsule with a material which is destroyed with the mechanical pressure or heat may be cited. These compounds, however, exhibit poor stability in a strong polar solvent and do not have sufficient mechanical strength capable of bearing a kneading process, and thus the formulation of the composition using these compounds suffers many restrictions. Accordingly, at present there is almost no example of putting the epoxy-based composition containing these compounds in use.
Therefore, in order to cope with the demand for long useful life of a photocurable and thermosetting composition aimed at, it will be necessary to find out a composition system which can realize such conditions that a thermal curing catalyst does not exist in a coating film until a development process, but a thermal curing catalyst is added to the coating film after development.
Patent literature 1: JP 61-243869,A (claims; page 3, left lower column, line 10 - page 4, left upper column, line 5; page 4, left lower column, lines 12-19)
Patent literature 2: JP 8-335768,A (claims)
Patent literature 3: JP 8-335767,A (claims)

### Disclosure of the Invention

### Problems to be Solved by the Invention

The present invention has been made in view of the problems of the conventional technology mentioned above and its principle object is to provide a composition for forming a cured film pattern and a method of producing a cured film pattern, which are capable of producing a cured film pattern of the negative type excelling in various properties by using a developing solution which can impart a thermal curing catalyst to the film simultaneously with the development even when a coating film formed on a substrate by the use of a photocurable and thermosetting composition containing no thermal curing catalyst is exposed to light, developed, and then thermally cured (post-cured).
A concrete object of the present invention is to provide a composition for forming a cured film pattern, which enjoys a long pot life (useful life) after mixing of a main agent and a hardener, excels in storage stability as a one-package formulation and is capable of forming a cured film pattern excelling in various properties, such as fastness of adhesion to various substrates, resistance to soldering heat, resistance to chemicals, resistance to electroless gold plating, and electrical insulating properties, by using the aforementioned developing solution which can impart a thermal curing catalyst to the film simultaneously with the development even when the photocurable and thermosetting composition contains no thermal curing catalyst, and to provide a method of producing a cured film pattern by the use of the composition.
A more concrete object of the present invention is to provide a composition for forming a cured film pattern, which is capable of forming a cured film pattern excelling in flexibility in addition to various properties mentioned above by using the aforementioned developing solution which can impart a thermal curing catalyst to the film simultaneously with the development even when the photocurable and thermosetting composition contains no thermal curing catalyst, and to provide a method of producing a cured film pattern by the use of the composition.

### Means for Solving the Problems

To accomplish the objects mentioned above, the present invention provides a composition for forming a cured film pattern. The fundamental embodiment of the composition is characterized by comprising a combination of:
an alkaline developable photocurable and thermosetting composition containing no thermal curing catalyst, which is used for forming a cured film pattern by subjecting a film formed on a substrate to exposure to light, development for removing an unexposed area, and thermal curing; and
a developing solution comprising an aqueous solution of a basic curing catalyst of a nitrogen-containing heterocyclic compound for promoting a thermosetting reaction.

In a preferred embodiment, the photocurable and thermosetting composition mentioned above comprises as essential components:
(A) a carboxylic group-containing photosensitive compound (A-1), or a carboxylic group-containing compound (A-2) and a compound containing an ethylenically unsaturated double bond (A-3),
(B) a photopolymerization initiator, and
(C) a thermosetting resin.

A more preferred embodiment of the composition for forming a cured film pattern according to the present invention is characterized by comprising a combination of:
a photocurable and thermosetting composition containing no thermal curing catalyst, which comprises as essential components:
   (A) a carboxylic group-containing photosensitive compound (A-1), or a carboxylic group-containing compound (A-2) and a compound containing an ethylenically unsaturated double bond (A-3),
   (B) a photopolymerization initiator,
   (C-1) an epoxy resin, and
   (C-2) an oxetane compound; and
a developing solution comprising an aqueous solution of a basic curing catalyst of a nitrogen-containing heterocyclic compound for promoting a thermosetting reaction.
In either embodiment mentioned above, the photocurable and thermosetting composition may be in the form of liquid or a so-called dry film.

In a preferred embodiment, the basic curing catalyst mentioned above is a heterocyclic compound having an amidine structure. In a more preferred embodiment, the heterocyclic compound having an amidine structure is at least one compound selected from the group consisting of 1,8-diazabicyclo[5.4.0]undeca-7-ene, 1,5-diazabicyclo[4.3.0]nona-5-ene, 1,4-diazabicyclo[2.2.2]octane, derivative salts thereof, and an imidazole compound. Among other basic curing catalysts, an imidazole compound, particularly 2-methylimidazole proves to be preferable.

In accordance with the present invention, there is further provided a method of producing a cured film pattern, characterized by comprising:
preparing the composition for forming a cured film pattern mentioned above for use,
selectively exposing a film of the photocurable and thermosetting composition containing no thermal curing catalyst to an actinic energy ray;
developing the film with the above-mentioned developing solution comprising an aqueous solution of a basic curing catalyst of a nitrogen-containing heterocyclic compound for promoting a thermosetting reaction, thereby removing an unexposed area of the film and doping an exposed area of the film with the basic curing catalyst mentioned above, and then
thermally curing the film to form a cured film pattern.

### Effects of the Invention

The composition for forming a cured film pattern and the method of producing a cured film pattern according to the present invention have a fundamental characteristic feature that in place of an alkaline developable photocurable and thermosetting composition containing a thermal curing catalyst which is heretofore commonly used, an alkaline developable photocurable and thermosetting composition containing no thermal curing catalyst is used in combination with a developing solution comprising an aqueous solution of a basic curing catalyst of a nitrogen-containing heterocyclic compound for promoting a thermosetting reaction. As a result, it is possible to prepare the photocurable and thermosetting composition to be used as a one-package composition excelling in storage stability and prolong its useful life after preparation of the composition. Further, since the aforementioned aqueous solution of a basic curing catalyst for promoting a thermosetting reaction is used as a developing solution which is used for developing and removing an unexposed area of a film of the aforementioned photocurable and thermosetting composition which has undergone the selective exposure to an actinic energy ray, the unexposed area of the film is removed and the exposed area of the film is doped with the basic curing catalyst mentioned above which has penetrated into the photocured film during the development. As a result, the film becomes excellent in thermosetting properties besides the patterning properties by development. Accordingly, by thermally curing the composition after development mentioned above, it is possible to obtain a cured film pattern excelling in various properties, such as electrical insulating properties, fastness of adhesion to a substrate, resistance to heat, resistance to chemicals, and resistance to electroless plating, which are required of a solder resist and an interlaminar insulating layer of a printed circuit board.

A more preferred embodiment of the composition for forming a cured film pattern according to the present invention is characterized by using as thermosetting components a polyfunctional epoxy resin of which curing reaction at the time of thermal curing is rapid together with an oxetane compound of which curing reaction is relatively slow. Accordingly, even when an aqueous solution containing a relatively large amount of a basic curing catalyst is used as a developing solution, the over-progress of the thermal curing reaction may be suppressed, thereby preventing the cured film from being hard and brittle and improving the adhesiveness. Further, by adjusting the amount of the oxetane compound of which curing reaction is relatively slow, it is possible to adjust the hardness of the resultant cured film. Accordingly, in cooperation with the functions and effects mentioned above, it is possible to obtain a cured film pattern excelling in flexibility besides the above-mentioned properties which are required of a solder resist and an interlaminar insulating layer of a printed circuit board by thermally curing the composition after development mentioned above.

Moreover, since the alkaline developable photocurable and thermosetting composition to be used in the present invention excels in storage stability because it does not contain a thermal curing catalyst, it is possible to prepare a photosensitive dry film which has excellent storage stability at room temperature by the use of this composition. Accordingly, the composition for forming a cured film pattern and the method of producing a cured film pattern by the use thereof according to the present invention are advantageous in the point of workability in the manufacture of printed circuit boards or the like.

### Best Mode for Carrying Out the Invention

The present inventors, after continuing a diligent study to accomplish the objects mentioned above, have found that it is possible to impart the patterning ability and a thermal curing catalyst to the composition by using a photocurable and thermosetting composition from which any thermal curing catalysts heretofore added thereto were eliminated entirely and by carrying out the development using an aqueous solution of a certain specific basic curing catalyst selected from the catalysts usually used as a thermal curing catalyst of epoxides to dope a coating film of the composition with the basic curing catalyst during the developing process.

That is, any thermal curing catalyst which has an adverse effect on the pot life after mixing of two package compositions or on the storage stability as a one package formulation is eliminated from the alkaline developable photocurable and the thermosetting composition heretofore known in the art to solve these problems, and in order to relieve the shortage of curing derived in connection therewith, the development for patterning is carried out by using an aqueous solution of a particular basic curing catalyst to cause penetration and doping of the basic curing catalyst into a coating film during the developing process. By this method, it is possible to cope with the prolongation of useful life which was a problem to be solved until now, to improve the range of drying management, the leaving time after coating, and also the leaving time after exposure which had the limits until now, and to give a large flexibility to the design of production line. Further, since the storage stability is improved, the form of a composition may also be freely set according to the purpose and the use regardless of a liquid state or a dry film state.

According to the present inventors' further researches, in the alkaline developable photocurable and the thermosetting composition heretofore known in the art, a polyfunctional epoxy resin having two or more epoxy groups in its molecule of which reactivity is relatively high is commonly used as a thermosetting component. Therefore, a cured film tends to become hard and brittle.

When making a cured film soft, generally the addition of an ingredient like a plasticizer to a composition will be considered. However, when a plasticizer is merely added to the composition, there are problems of causing the bleedout (oozing) of the plasticizer to the cured film surface and the swelling and peeling of the cured film when a test for heat resistance and a test for chemical resistance required of a solder resist are performed.
The present inventors, after pursuing a further study on the phenomena mentioned above, have found that when a polyfunctional epoxy resin of which curing reaction at the time of thermal curing is rapid is used together with an oxetane compound of which curing reaction is relatively slow, the over-progress of the thermal curing reaction may be suppressed, without causing the bleedout of a plasticizer to the cured film surface as in the case of the addition of a plasticizer, even when an aqueous solution containing a relatively large amount of a basic curing catalyst allowing development is used as a developing solution, thereby preventing the cured film from being hard and brittle and improving the adhesiveness, and further that it is possible to adjust the hardness of the resultant cured film by adjusting the amount of the oxetane compound of which curing reaction is relatively slow.

Now, the photocurable and the thermosetting composition and the developing solution to be used in the present invention will be described in detail below.
First, since the main object of the present invention is to prolong the useful life of a photocurable and thermosetting composition or to stabilize the composition as a one package formulation, it is necessary to eliminate a thermal curing catalyst from the composition. Besides, insofar as the photocurable and thermosetting composition contains an alkaline developable group, such as a carboxyl group, and a photosensitive group therein, both the patterning of a coating film and the doping of a thermal curing catalyst into the film may be performed according to the method of the present invention. Further, since the method of the present invention performs the doping by causing penetration of a thermal curing catalyst into a coating film during the developing process, it is necessary to use as a developing solution an aqueous solution of the basic curing catalyst for promoting the reaction of the functional group of a thermosetting component such as, for example, an epoxy group, an isocyanate group, and an oxetanyl group.

A thermal curing catalyst which can be used for the process allowing the above-mentioned patterning of a coating film and the doping of a thermal curing catalyst into the film should satisfy the requirements that it can dissolve in water to form a solution and that the solution should exhibit the basic nature. Although an aqueous solution containing a low boiling point amine, such as NH₃, methylamine, dimethylamine, triethylamine, and morpholine, which are generally cited by a photolithographic process, allows the patterning of a coating film when used as a developing solution. However, they volatilize or decompose at the time of post-cure and cannot remain in the coating film as a thermal curing catalyst, thereby failing to exhibit sufficient curing catalyst function. Further, although pyridine and dicyandiamide which can serve as a thermal curing catalyst at the time of the usual thermal curing reaction easily dissolve in water, they have no patterning ability as a developing solution. Accordingly, they do not penetrate into a coating film and fail to dope it during the development and thus cannot act as a thermal curing catalyst at the time of post-cure when used in the above-mentioned process.

The present inventors have found that a heterocyclic compound containing a nitrogen atom is optimal as a basic curing catalyst which has the patterning ability as a developing solution and can contribute to the curing reaction of a thermosetting component, such as an epoxy resin and an oxetane compound, at the time of post-cure. Such a nitrogen-containing heterocyclic compound includes five-membered heterocyclic compounds, such as pyrrole and a pyrazole, and six-membered heterocyclic compounds, such as piperazine. Among other compounds, a heterocyclic compound having the amidine structure proves to be particularly preferable. For example, organic strong bases such as 1,8-diazabicyclo[5.4.0]undeca-7-ene (abbreviation: DBU), 1,5-diazabicyclo[4.3.0]nona-5-ene (abbreviation: DBN), and 1,4-diazabicyclo[2.2.2]octane (abbreviation: DABCO), derivative salts thereof such as phenol salts, octylic acid salts, p-toluene sulfonates, o-phthalates, formates, phenol novolak resin salts, and tetraphenyl borates, and other various derivatives such as imidazole compounds and pyrimidine may be cited. As DBU salts and DBN salts, U-CAT (registered trademark) series and U-CAT SA series manufactured by Sun-Apro K.K., for example, may be cited, and as the imidazole compounds, imidazole, 1-methylimidazole, 2-methylimidazole, and 1,2-dimethylimidazole may be cited as a compound having well-balanced developing ability and catalytic effects, but not limited to these compounds.

These basic curing catalysts may be used either singly or in the form of a mixture of two or more members. In order to give the contrast in patterning of a coating film, it is preferred to adjust the pH of each solution to the range of 9 to 14, more preferably 10 to 14. The amount of the above-mentioned basic curing catalyst to be incorporated into a developing solution, i.e. the concentration in the solution, is desired to be not less than 0.1% by weight and not more than 20% by weight, preferably not less than 0.2% by weight and not more than 10% by weight, more preferably not less than 0.3% by weight and not more than 5% by weight, of the whole developing solution from the viewpoint of imparting sufficient curing catalyst to a coating film. If the concentration of the basic curing catalyst in the solution exceeds 20% by weight, it exerts large influence on the exposed portion of the film and tends to cause surface damage and an undercut in the coating film. As a result, the margin of development will become small, exfoliation of the coating film will arise or it will be possible to establish good contrast only with difficulty. Conversely, if the concentration is less than 0.1% by weight, it will be possible to establish good contrast only with difficulty due to the unduly low concentration, and even if the development time is prolonged, the produced coating film will suffer persistence therein of an undeveloped residue.

Next, the photocurable and thermosetting composition which can be used in the present invention will be described. As the composition which can be used in the present invention, various alkaline developable photocurable and thermosetting compositions heretofore known in the art may be used insofar as they do not contain any thermal curing catalyst for the purpose of establishing long useful life or the storage stability as a one-package formulation. Preferably, the photocurable and thermosetting composition to be used in the present invention contains a carboxyl group-containing photosensitive prepolymer (A-1), or a carboxyl group-containing compound (A-2) and a compound having an ethylenically unsaturated double bond (A-3), a photopolymerization initiator (B), and a thermosetting resin (C) as essential components.

In a preferred embodiment of the photocurable and thermosetting composition which is capable of forming a cured film excelling in adhesiveness and flexibility and allows suppression of the over-progress of the thermal curing reaction, thereby preventing the cured film from being hard and brittle, even when an aqueous solution containing a relatively large amount of the basic curing catalyst is used, various alkaline developable photocurable and thermosetting compositions heretofore known in the art may be used insofar as they do not contain any thermal curing catalyst for the purpose of establishing long useful life or the storage stability as a one-package formulation and use an epoxy resin together with an oxetane compound as thermosetting components. Preferably, such a photocurable and thermosetting composition contains a carboxyl group-containing photosensitive compound (A-1), or a carboxyl group-containing compound (A-2) and a compound having an ethylenically unsaturated double bond (A-3), a photopolymerization initiator (B), an epoxy resin (C-1), and an oxetane compound (C-2) as essential components.

The carboxyl group-containing photosensitive compound (A-1) mentioned above is a compound having at least one, preferably two or more carboxyl groups and ethylenically unsaturated double bonds in its molecule, respectively. On the other hand, the carboxyl group-containing compound (A-2) mentioned above is a compound having one, preferably two or more carboxyl groups in its molecule. Since this compound (A-2) has no ethylenically unsaturated double bond in itself, when it is used singly, it is necessary to use it in combination with the above-mentioned compound having an ethylenically unsaturated double bond (A-3). Although both of the carboxyl group-containing photosensitive compound (A-1) having an ethylenically unsaturated double bond and the carboxyl group-containing compound (A-2) having no ethylenically unsaturated double bond in itself mentioned above are alkali soluble components, they may be used without being limited to a particular one. Particularly, the compounds (any of oligomer or polymer may be sufficient) enumerated below can be advantageously used.

(1) A carboxyl group-containing compound obtained by the copolymerization of (a) an unsaturated carboxylic acid, such as (meth)acrylic acid, with (b) a compound having an unsaturated double bond, such as styrene, α-methylstyrene, low-molecular alkyl (meth)acrylate, and isobutylene,
(2) a carboxyl group-containing photosensitive compound obtained by causing a compound having an ethylenically unsaturated group such as a vinyl group, an allyl group, and a (meth)acryloyl group and a reactive group such as an epoxy group and an acid chloride, for example, glycidyl (meth)acrylate, to react with a part of a copolymer of (a) an unsaturated carboxylic acid and (b) a compound having an unsaturated double bond, thereby adding the ethylenically unsaturated group of the compound to the copolymer as a pendant,
(3) a carboxyl group-containing photosensitive compound obtained by causing (a) an unsaturated carboxylic acid to react with a copolymer of (c) a compound having a epoxy group and an unsaturated double bond, such as glycidyl (meth)acrylate and α -methylglycidyl (meth)acrylate, and (b) a compound having an unsaturated double bond, and then causing (d) a saturated or unsaturated polybasic acid anhydride, such as phthalic anhydride, tetrahydrophthalic anhydride, and hexahydrophthalic anhydride, to react with the secondary hydroxyl group caused by the above reaction,
(4) a carboxyl group-containing photosensitive compound obtained by causing (f) a compound having a hydroxyl group and an unsaturated double bond, such as hydroxyalkyl (meth)acrylate, to react with a copolymer of (e) an acid anhydride having an unsaturated double bond, such as maleic anhydride and itaconic anhydride, and (b) a compound having an unsaturated double bond,
(5) a carboxyl group-containing photosensitive compound obtained by the esterification (complete esterification or partial esterification, preferably complete esterification) of an epoxy group of (g) a polyfunctional epoxy compound having at least two epoxy groups in its molecule with a carboxyl group of (h) an unsaturated monocarboxylic acid, such as (meth)acrylic acid, and the subsequent reaction of (d) a saturated or unsaturated polybasic acid anhydride with a resultant hydroxyl group produced in the esterification, and
(6) a carboxyl group-containing compound obtained by causing (i) an organic acid having one carboxyl group and no ethylenically unsaturated bond in its molecule, such as alkyl carboxylic acid of 2 to 17 carbon atoms and aromatic group-containing alkyl carboxylic acid, to react with an epoxy group of a copolymer of (b) a compound having an unsaturated double bond and glycidyl (meta)acrylate and then causing (d) a saturated or unsaturated polybasic acid anhydride to react with the secondary hydroxyl group caused by the above reaction may be cited. However, the carboxyl group-containing compound is not limited to those enumerated above.

The acid values of the carboxyl group-containing photosensitive compound (A-1) and the carboxyl group-containing compound (A-2) mentioned above are desired to be in the range of 20 to 200 mgKOH/g, preferably in the range of 50 to 120 mgKOH/g. If the acid value is less than 20 mgKOH/g, the compounds will manifest insufficient solubility in an aqueous alkaline solution and the development of the formed coating film will be performed only with difficulty. Conversely, the acid value exceeding 200 mgKOH/g is undesirable because the dissolving out of the exposed area in a developing solution will proceed regardless of the exposure conditions.
The carboxyl group-containing photosensitive compound (A-1) and the carboxyl group-containing compound (A-2) mentioned above may be used either singly or in the form of a combination of two or more members.

As described above, in the case of a composition containing the carboxyl-group containing compound (A-2) having no ethylenically unsaturated double bond, the compound (A-3) having an ethylenically unsaturated double bond serves as an indispensable component. On the other hand, in the case of a composition containing the carboxyl group-containing photosensitive compound (A-1) having an ethylenically unsaturated double bond, it is possible to photo-cure the composition even if it does not necessarily contain the compound (A-3) having an ethylenically unsaturated double bond. However, for the purpose of acquiring sufficient photo-curing depth, it is preferred to incorporate the compound (A-3) having an ethylenically unsaturated double bond into the composition.

As typical examples of the compound (A-3) having an ethylenically unsaturated double bond, 2-hydroxyethyl acrylate, 2-hydroxypropyl acrylate, N-vinylpyrrolidone, acryloyl morpholine, methoxytetraethylene glycol acrylate, methoxypolyethylene glycol acrylate, polyethylene glycol diacrylate, N,N-dimethyl acrylamide, N-methylol acrylamide, N,N-dimethylaminopropyl acrylamide, N,N-dimethylaminoethyl acrylate, N,N-dimethylaminopropyl acrylate, melamine acrylate, diethylene glycol diacrylate, triethylene glycol diacrylate, propylene glycol diacrylate, dipropylene glycol diacrylate, tripropylene glycol diacrylate, polypropylene glycol diacrylate, phenoxyethyl acrylate, tetrahydrofurfuryl acrylate, cyclohexyl acrylate, glycerin diglycidyl ether diacrylate, glycerin triglycidyl ether triacrylate, isobornyl acrylate, cyclopentadiene mono- or di-acrylate; polyfunctional acrylates of polyhydric alcohols such as hexane diol, trimethylol propane, pentaerythritol, ditrimethylol propane, dipentaerythritol, and tris-hydroxyethyl isocyanurate and of ethylene oxide or propylene oxide adducts thereof; methacrylates corresponding to the acrylates enumerated above, and mono-, di-, tri-, and higher polyesters of polybasic acids with hydroxyalkyl (meth)acrylates may be cited. These compounds may be used either singly or in the form of a combination of two or more members.

The aforementioned compound (A-3) having an ethylenically unsaturated double bond is used for the purpose of diluting the aforementioned carboxyl group-containing compounds (A-1 and/or A-2) or the like thereby rendering the produced composition easily applicable, and imparting (in the case of the carboxyl group-containing compound having no ethylenically unsaturated double bond) or improving (in the case of the carboxyl group-containing photosensitive compound having an ethylenically unsaturated double bond) the photopolymerizability upon the composition. The preferred amount of the compound (A-3) to be used is not less than 3 parts by weight and not more than 50 parts by weight, based on 100 parts by weight of the carboxyl group-containing compound (A-1 and/or A-2) mentioned above (a total amount of A-1 and A-2, or an independent amount in the case of single use, this holds good for the same expression to be described hereinafter). If the amount of the compound is less than 3 parts by weight, the composition will be at a disadvantage in failing to impart or enhance the photo-curing properties. Conversely, if the amount exceeds 50 parts by weight, the composition will be at a disadvantage in failing to heighten dryness of a coating film to the tack-free touch of finger.

As the photopolymerization initiator (B) mentioned above, any known compounds which generate radicals by irradiation of an actinic energy ray may be used. For example, benzoin and alkyl ethers thereof such as benzoin, benzoin methyl ether, benzoin ethyl ether, and benzoin isopropyl ether; acetophenones such as acetophenone, 2,2-dimethoxy-2-phenyl acetophenone, 2,2-diethoxy-2-phenyl acetophenone, and 1,1-dichloroacetophenone; aminoacetophenones such as 2-methyl-1-[4-(methylthio)phenyl]-2-morpholinopropane-1-one, 2-benzyl-2-dimethylamino-1-(4-morpholinophenyl)-butane-1-one, and N,N-dimethylamino-acetophenone; anthraquinones such as 2-methylanthraquinone, 2-ethylanthraquinone, 2-tert-butylanthraquinone, and 1-chloro-anthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; organic peroxides such as benzoyl peroxide and cumene peroxide; dimer of 2,4,5-triaryl imidazole; riboflavin tetrabutylate; thiol compounds such as 2-mercaptobenzimidazole, 2-mercaptobenzoxazole, and 2-mercaptobenzothiazole; organic halogen compounds such as 2,4,6-tris-s-triazine, 2,2,2-tribromoethanol, and tribromomethyl phenyl sulfone; benzophenones such as benzophenone and 4,4'-bis(diethylamino)benzophenone; xanthones; and 2,4,6-trimethylbenzoyl diphenyl phosphine oxide may be cited. As the other examples, acridine compounds and oxime esters may be cited. These well known and widely used photopolymerization initiators may be used either singly or in the form of a combination of two or more members. The amount of the photopolymerization initiator (B) to be used may be in the conventionally used range, usually not less than 0.2 part by weight and not more than 30 parts by weight, based on 100 parts by weight of the carboxyl group-containing compound (A-1 and/or A-2) mentioned above.

Next, as the thermosetting resin (C) mentioned above, various thermosetting resins heretofore known in the art may be used. For example, novolak type phenolic resins such as phenol novolak resin, cresol novolak resin, and bisphenol A novolak resin; phenolic resins such as resol phenol resin; bisphenol type epoxy resins such as bisphenol A epoxy resin and bisphenol F epoxy resin; novolak type epoxy resins such as novolak epoxy resin and cresol novolak epoxy resin; epoxy resins such as biphenyl type epoxy resins, stilbene type epoxy resins, triphenolmethane type epoxy resins, alkyl-modified triphenolmethane type epoxy resin, hydrogenated epoxy resins derived from these epoxy resins, triazine skeleton-containing epoxy resins, dicyclopentadiene-modified phenol type epoxy resins, and alicyclic epoxy resins; urea resins, resins having a triazine ring such as melamine resin, unsaturated polyester resins, bismaleimide resins, polyurethane resins, diallyl phthalate resins, silicone resins, resins having a benzoxazine ring, cyanate ester resins, and polyfunctional oxetane compounds, etc. may be cited. These thermosetting resins may be used either singly or in the form of a combination of two or more members. Among other thermosetting resins, the polyfunctional epoxy resins having at least two epoxy groups in its molecule can be advantageously used. Generally, the sufficient amount of the thermosetting resin to be incorporated into the composition is not less than 10 parts by weight and not more than 100 parts by weight, based on 100 parts by weight of the carboxyl group-containing compound (A-1 and/or A-2) mentioned above.

In a particularly preferred embodiment of the photocurable and thermosetting composition of the present invention, an epoxy resin (C-1) is used together with an oxetane compound (C-2) as thermosetting components.
As the epoxy resin (C-1), various polyfunctional epoxy compounds containing at least two epoxy groups in its molecule heretofore known in the art may be used. For example, bisphenol A type epoxy resins, hydrogenated bisphenol A type epoxy resins, brominated bisphenol A type epoxy resins, bisphenol F type epoxy resins, bisphenol S type epoxy resins, novolak type epoxy resins, phenol novolak type epoxy resins, cresol novolak type epoxy resins, bisphenol A novolak type epoxy resins, N-glycidyl type epoxy resins, hydantoin type epoxy resins, alicyclic epoxy resins, trihydroxyphenyl methane type epoxy resins, bixylenol type epoxy resins, biphenol type epoxy resins, chelate type epoxy resins, glyoxal type epoxy resins, amino group-containing epoxy resins, tetraphenylol ethane type epoxy resins, heterocyclic epoxy resins, diglycidyl phthalate resins, tetraglycidyl xylenoyl ethane resins, naphthalene group-containing epoxy resins, dicyclopentadiene skeleton-containing epoxy resins, glycidylmethacrylate copolymer type epoxy resins, copolymeric epoxy resins of cyclohexylmaleimide and glycidyl methacrylate, rubber-modified epoxy resins, silicone-modified epoxy resins, ε -caprolacton-modified epoxy resins, etc. may be cited, but are not limited to these resins. Further, the epoxy resins into which structure an atom such as halogen like chlorine and bromine or phosphorus has been introduced for imparting flame retardancy thereto may be used. These epoxy resins may be used either singly or in the form of a combination of two or more members.

As the oxetane compound (C-2), various oxetane compounds containing at least one oxetanyl group in its molecule may be used either singly or in the form of a combination of two or more members. As the monofunctional oxetane compound containing one oxetanyl group in its molecule, for example, 3-methyloxetane, 3-ethyloxetane, 3-hydroxymethyloxetane, 3-methyl-3-hydroxymethyloxetane, and 3-ethyl-3-hydroxymethyloxetane may be cited. As the polyfunctional oxetane compound containing at least two oxetanyl groups in its molecule, for example, bis[(3-methyl-3-oxetanylmethoxy)methyl] ether, bis[(3-ethyl-3-oxetanylmethoxy)methyl] ether, 1,4-bis[(3-methyl-3-oxetanylmethoxy)methyl] benzene, 1,4-bis[(3-ethyl-3-oxetanylmethoxy)methyl] benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl methacrylate, oligomers or copolymers of these oxetane compounds, and etherified products of an oxetane with a hydroxyl group-containing resin, such as a novolak resin, poly(p-hydroxystyrene), cardo type bisphenols, calixarenes, calixresorcinarenes, or silsesquioxane, may be cited. Besides, copolymers of an unsaturated monomer having an oxetane ring with an alkyl (meth)acrylate may be cited. Among other oxetane compounds, the polyfunctional oxetane compounds containing at least two oxetanyl groups in its molecule prove to be preferable.

In general, the sufficient amount of the epoxy resin (C-1) and the oxetane compound (C-2) to be incorporated into the composition is not less than 10 parts by weight and not more than 100 parts by weight, based on 100 parts by weight of the carboxyl group-containing compound (A-1 and/or A-2) mentioned above. Further, the proper compounding ratio of the epoxy resin (C-1) to the oxetane compound (C-2) mentioned above is (C-1) : (C-2) = 100 : 5-100, preferably (C-1) : (C-2) = 100 : 10-90. By adjusting the amount of the oxetane compound (C-2) of which curing reaction is relatively slow within the range mentioned above, it is possible to adjust the hardness of a cured film obtained.

The photocurable and thermosetting composition to be used in the present invention may incorporate therein an organic solvent for the purpose of dissolving the carboxyl group-containing photosensitive compound (A-1), the carboxyl group-containing compound (A-2), the compound (A-3) containing an ethylenically unsaturated double bond, or the like and adjusting the composition to such a degree of viscosity suitable for a varying method of application.
As the organic solvent, for example, ketones such as methyl ethyl ketone and cyclohexanone; aromatic hydrocarbons such as toluene, xylene and tetramethyl benzene; glycol ethers such as ethylene glycol monoethyl ether, ethylene glycol monomethyl ether, ethylene glycol monobutyl ether, diethylene glycol monoethyl ether, diethylene glycol monomethyl ether, diethylene glycol monobutyl ether, propylene glycol monomethyl ether, propylene glycol monoethyl ether, dipropylene glycol diethyl ether, and triethylene glycol monoethyl ether; acetates such as ethyl acetate, butyl acetate, ethylene glycol monoethyl ether acetate, ethylene glycol monobutyl ether acetate, diethylene glycol monoethyl ether acetate, diethylene glycol monobutyl ether acetate, propylene glycol monomethyl ether acetate, and dipropylene glycol monomethyl ether acetate; alcohols such as ethanol, propanol, ethylene glycol, and propylene glycol; aliphatic hydrocarbons such as octane and decane; and petroleum solvents such as petroleum ether, petroleum naphtha, hydrogenated petroleum naphtha, and solvent naphtha may be cited. These organic solvents may be used either singly or in the form of a mixture of two or more members. The amount of the organic solvent to be incorporated into the composition may be arbitrarily set according to a use etc.

The photocurable and thermosetting composition to be used in the present invention may further incorporate therein, as occasion demands, any of known and commonly used inorganic fillers such as barium sulfate, barium titanate, amorphous silica, crystalline silica, fused silica, spherical silica, talc, clay, magnesium carbonate, calcium carbonate, aluminum oxide, aluminum hydroxide, and mica, any of known and commonly used coloring agents such as phthalocyanine blue, phthalocyanine green, iodine green, disazo yellow, crystal violet, titanium oxide, carbon black, and naphthalene black, any of known and commonly used thermal polymerization inhibitors such as hydroquinone, hydroquinone monomethyl ether, tert-butyl catechol, pyrogallol, and phenothiazine, any of known and commonly used thickening agents such as finely powdered silica, organobentonite, and montmorillonite, silicone type, fluorine type, or macromolecular type anti-foaming agents and/or leveling agents, silane coupling agents, or any other known and commonly used additives.

The photocurable and thermosetting composition to be used in the present invention may also be prepared in the state of a dry film or an adhesive film provided with a supporting member and a layer of the above-mentioned photocurable and thermosetting composition formed on this supporting member. Preferably, a peelable cover film is further laminated on the layer of the curable composition of the above-mentioned film. Since the thermosetting components (an epoxy resin, an oxetane compound, etc.) in the photocurable and thermosetting composition are almost unreacted in the stage after patterning by development, the thermosetting components can ooze out on the film surface by a pressing treatment or a thermal pressing treatment, and the film can be adhered to an object to be attached. The unreacted thermosetting resin portion acts also as a plasticizer of the already cured photocurable resin portion, thereby enhancing the adhesion to the object to be attached. By selecting the thickness of the film, the adhesive layer formed between two objects to be adhered in this way can also act as a spacer.

As the supporting member, a plastic film is used. It is preferred that a transparent or light-permeable plastic film such as a polyester film like polyethylene terephthalate, a polyimide film, a polyamidoimide film, a polypropylene film, and a polystyrene film be used. Here, the thickness of the supporting member is usually selected within the range of 10 to 150 µm properly.

The layer of the curable composition mentioned above on a supporting member is formed by applying the photocurable and thermosetting composition mentioned above on a supporting member by a comma coater, a blade coater, a lip coater, a rod coater, a squeeze coater, a reverse coater, a transfer roll coater, or the like to uniform thickness and dried by heating to volatilize a solvent. The thickness is not restricted to a particular one and usually selected within the range of 10 to 150 µm properly.

As the cover film mentioned above, a polyethylene film, a polypropylene film, a Teflon (registered trademark) film, a paper subjected to a surface treatment, or the like are usually used. Any cover film may be used provided that the adhesive strength between the layer of the curable composition mentioned above and the cover film is smaller than the adhesive strength between the layer of the curable composition mentioned above and a supporting member and not limited to a specific one.

The photocurable and thermosetting composition having such a composition as described above is, if it is in the liquid state, adjusted to a level of viscosity suitable for a particular coating method by dilution when necessary, then applied by the technique of screen printing, curtain coating, spray coating, roll coating, or the like to a printed circuit board having a circuit formed in advance thereon, and then dried at a temperature in the approximate range of 60 to 100°C, for example, to expel by evaporation the organic solvent contained in the composition to produce a tack-free coating film. In the case of a dry film provided with a supporting member and the layer of the above-mentioned photocurable and thermosetting composition formed on this supporting member, it can be laminated on a printed circuit board having a circuit formed in advance thereon by means of a vacuum laminator or the like to form a film on the printed circuit board. The lamination is carried out in such a way that the layer of the above-mentioned photocurable and thermosetting composition is brought into contact with the printed circuit board having a circuit formed in advance thereon. In the case of a dry film provided with a peelable cover film on the layer of the curable composition of the film mentioned above, after separating the cover film from the dry film, the dry film can be laminated on a printed circuit board having a circuit formed in advance thereon by means of a vacuum laminator or the like in such a way that the layer of the above-mentioned curable composition is brought into contact with the printed circuit board to form a film on the printed circuit board.

After forming the coating film on the printed circuit board having a circuit formed in advance thereon (when the above-mentioned dry film is used, the supporting member is not removed), the coating film is exposed to an actinic energy ray such as laser beam by projecting the laser beam directly on the coating film according to a prescribed pattern or selectively exposed to an actinic energy ray through a photomask having a prescribed exposure pattern, and the unexposed area of the coating film is developed with the developing solution of the present invention mentioned above to form a resist pattern (when the above-mentioned dry film is used, the supporting member is removed after exposure and the film is then developed). The patterned film is finally cured by being further subjected to the thermal curing only, or the thermal curing after irradiation with the actinic energy ray, or the irradiation with the actinic energy ray after thermal curing to form a cured film (a cured product) which excels in fastness of adhesion, resistance to soldering heat, resistance to chemicals, resistance to electroless gold plating, electrical insulating properties, and PCT (pressure cooker test) resistance.

Suitable light sources which are advantageously used for the purpose of photocuring the composition include a low-pressure mercury vapor lamp, a medium-pressure mercury vapor lamp, a high-pressure mercury vapor lamp, an ultra-high-pressure mercury vapor lamp, a xenon lamp, and a metal halide lamp, for example. Also, a laser beam may be used as the actinic energy ray.

### Examples

Now, the present invention will be more specifically described below with reference to working examples. It should be noted, however, that the following Examples are intended to be merely illustrative of and in any sense restrictive of the present invention. Wherever "parts" is mentioned hereinbelow, it invariably refers to that based on weight unless otherwise specified.

### <Synthetic Example>

In a flask equipped with a thermometer, a stirrer, a dropping funnel, and a reflux condenser, 210 parts of a cresol novolak type epoxy resin (product of Dainippon Ink & Chemicals, Inc., EPICLON (registered trademark) N-680, epoxy equivalent; 210) and 96.4 parts of carbitol acetate added thereto were dissolved by heating. Then, the solution was made to add 0.1 part of hydroquinone as a polymerization inhibitor and 2.0 parts of triphenylphosphine as a reaction catalyst. The resultant mixture kept heated to 95 - 105°C and 72 parts of acrylic acid gradually added dropwise thereto were left reacting for about 16 hours until the acid value becomes below 3.0 mgKOH/g. The reaction product was cooled to 80 - 90°C and made to add 76.1 parts of tetrahydrophthalic anhydride and they were left reacting for about 6 hours until the absorption peak at 1780 cm⁻¹ originated from the acid anhydride measured by the infrared spectroscopic analysis disappears. The reaction solution was diluted with 96.4 parts of an aromatic solvent (IPSOL (registered trademark) #150 produced by Idemitsu Petrochemical Co., Ltd.) added thereto and then extracted from the flask. The varnish of the resin containing two or more of acryloyl groups and carboxyl groups together which was consequently obtained was found to have a nonvolatile content of 65% and an acid value of 78 mgKOH/g as solids. This resin varnish will be referred to hereinafter as "R-1 varnish".

### <Preparation of Developing Solutions>

Developing solution R: A developing solution R (1 wt.%) was prepared by mixing one part by weight of Na₂CO₃ (produced by Wako Pure Chemical Industries Ltd.) into 99 parts by weight of demineralized water and stirring them.
Developing solution A: A developing solution A (1 wt.%) was prepared by mixing DBU (1, 8-diazabicyclo[5.4.0]undeca-7-ene produced by Wako Pure Chemical Industries Ltd.) into demineralized water and stirring them in the same manner as described above.
Developing solution B: A developing solution B-1 (1 wt.%) and a developing solution B-2 (2 wt.%) were prepared by mixing 2-methyl imidazole (produced by Shikoku Kasei Kogyo K.K. under product code of 2MZ) into demineralized water and stirring them in the same manner as described above, respectively.
Developing solution C: A developing solution C (5 wt.%) was prepared by mixing dicyandiamide into demineralized water and stirring them in the same manner as described above.
Developing solution D: A developing solution D (10 wt.%) was prepared by mixing pyridine (produced by Wako Pure Chemical Industries Ltd.) into demineralized water and stirring them in the same manner as described above.
Developing solution E: A developing solution E (1 wt.%) was prepared by mixing morpholine (produced by Wako Pure Chemical Industries Ltd.) into demineralized water and stirring them in the same manner as described above.
Developing solution F: A developing solution F (1 wt.%) was prepared by mixing triethylamine (TEA) (produced by Wako Pure Chemical Industries Ltd.) into demineralized water and stirring them in the same manner as described above.

### <Preparation of Photocurable and Thermosetting Compositions>

### Compositions 1 to 4 and Comparative Compositions 1, 2:

The compositions 1 to 4 and comparative compositions 1, 2 were prepared by compounding and stirring the components accounting for varying ratios of combination shown in Table 1 and kneading them with a three-roll mill for dispersion, respectively. Incidentally, "NV" in Table 1 represents a nonvolatile content.

**[Table 1]**

| Components (parts by weight) | | Composition No. | | | | Comparative Composition No. | |
|---|---|---|---|---|---|---|---|
| | | 1 | 2 | 3 | 4 | 1 | 2 |
| Resin varnish R-1 (NV: 65%) | | 154.0 | 154.0 | - | - | 154.0 | 154.0 |
| Photosensitive resin (NV: 39%)*¹ | | - | - | 256.4 | - | - | - |
| Polycarboxylic resin (NV: 55%)*² | | - | - | - | 181.8 | - | - |
| Acrylate monomer *³ | | 25.0 | 25.0 | 25.0 | 25.0 | 25.0 | 25.0 |
| Epoxy resin varnish *⁴ | | 50.0 | - | 30.0 | 56.0 | 50.0 | 50.0 |
| Epoxy resin *⁵ | | 20.0 | - | 12.0 | 22.0 | 20.0 | 20.0 |
| Epoxy resin *⁶ | | - | 30.0 | - | - | | - |
| Photopolymerization initiator *⁷ | | 15.0 | 15.0 | 15.0 | 15.0 | 15.0 | 15.0 |
| Curing catalyst *⁸ | | - | - | - | - | 0.5 | - |
| Curing catalyst *⁹ | | - | - | - | - | - | 0.5 |
| Silicone-based anti-foaming agent *¹⁰ | | 1.0 | 1.0 | 1.0 | 1.0 | 1.0 | 1.0 |
| Solvent *¹¹ | | 2.0 | 2.0 | 2.0 | 2.0 | 2.0 | 2.0 |
| Total | | 267.0 | 227.0 | 341.4 | 302.8 | 267.5 | 267.5 |
| Remarks | *¹ : Cyclomer (ACA) Z320 manufactured by Daicel Chemical Industries Ltd. | | | | | | |
| | *² : Vanaresin PSY-3044 manufactured by Shin-Nakamura Chemical Co., Ltd. | | | | | | |
| | *³ : ARONIX M6200 manufactured by TOAGOSEI CO., LTD. | | | | | | |
| | *⁴ : Varnish of JER 1001 manufactured by Japan Epoxy Resin K.K. diluted with carbitol acetate (NV: 75%) | | | | | | |
| | *⁵ : JER 828 manufactured by Japan Epoxy Resin K.K. | | | | | | |
| | *⁶ : RE-306CA90 manufactured by Nippon Kayaku Co., Ltd. | | | | | | |
| | *⁷ : Irgacure (registered trademark) 907 manufactured by Ciba Specialty Chemicals K.K. | | | | | | |
| | *⁸ : Dicyandiamide | | | | | | |
| | *⁹ : Curezole (registered trademark) 2MZ manufactured by Shikoku Kasei Kogyo K.K. | | | | | | |
| | *¹⁰ : KS-66 manufactured by Shin-Etsu Silicone Co., Ltd. | | | | | | |
| | *¹¹ : Dipropylene glycol monomethylether | | | | | | |

### <Patterning properties with respective developing solutions>

Each of the compositions shown in Table 1 mentioned above was applied by screen printing to the entire surface of a copper-clad substrate to form a coating film of about 30 µm thickness and then dried at 80°C for 30 minutes by heating. Thereafter, the coating film on the substrate was exposed to light through a photomask by the use of a metal halide lamp and then developed with respective developing solutions. The criterion for evaluation is as follows:
○: No residue was observed after development and thus the patterning was performed.
×: Residue was observed after development.

### <Resistance to soldering heat>

Each of the compositions mentioned above was applied by screen printing to the entire surface of a printed circuit board having a circuit formed in advance thereon to form a coating film of about 30 µm thickness and then dried at 80°C for 30 minutes by heating. Thereafter, the coating film on the board was exposed to light through a negative film under the conditions of irradiation dose of 400 mJ/cm². Then, the coating film was developed for one minute with a developing solution and further thermally cured at 150°C for 60 minutes to prepare a test substrate.
Each of the test substrates obtained in this way was coated with a rosin-based flux and immersed in a solder bath set in advance at 260°C for 30 seconds, and visually examined as to swelling, exfoliation and discoloration of the cured film. The criterion for evaluation is as follows:
○: No discernable change was observed.
×: Swelling or exfoliation of the coating film was observed.

### <Test for resistance to solvent>

The test substrates which have undergone the test for the resistance to soldering heat mentioned above were used. Each test piece was immersed in propylene glycol monomethyl ether acetate for 30 minutes. After drying the test piece, the cured film was subjected to a peel test with an adhesive tape and visually examined the presence or absence of exfoliation of the cured film. The criterion for evaluation is as follows:
○: No exfoliation of the cured film was observed.
×: Exfoliation of the cured film was observed.

### <Insulating properties>

Test pieces were prepared by following the procedure of the test for the resistance to soldering heat mentioned above while using a comb electrode B coupon of IPC B-25 test pattern in the place of the printed circuit board. Each test piece was tested for initial insulating resistance by application of a bias voltage of DC 500V to the comb electrode.

### <Test for over-drying>

Each of the compositions mentioned above was applied by screen printing to the entire surface of a printed circuit board having a circuit formed in advance thereon to form a coating film of about 30 µm thickness and then dried at 80°C for 90 minutes by heating. Thereafter, the coating film on the board was developed with respective developing solutions and visually examined the presence or absence of the residue after development. The criterion for evaluation is as follows:
○: No residue was observed after development.
×: Residue was observed after development.

### <Test for useful life>

Each of the compositions mentioned above was left standing for 72 hours at 25°C after preparation, then applied by screen printing to the entire surface of a printed circuit board having a circuit formed in advance thereon to form a coating film of about 30 µm thickness, and dried at 80°C for 30 minutes by heating. Thereafter, the coating film on the board was developed with respective developing solutions and visually examined the presence or absence of the residue after development. The criterion for evaluation is as follows:
○: No residue was observed after development.
×: Residue was observed after development.

The results of respective tests mentioned above are shown in Table 2 and Table 3.

**[Table 2]**

| | Example No. | | | | | | |
|---|---|---|---|---|---|---|---|
| | 1 | 2 | 3 | 4 | 5 | 6 | 7 |
| Curable composition | No. 1 | No. 4 | No. 1 | No. 1 | No. 2 | No. 3 | No. 4 |
| Developing solution | A | A | B-1 | B-2 | B-2 | B-2 | B-2 |
| | 1% DBU | 1% DBU | 1% 2MZ | 2% 2MZ | 2% 2MZ | 2% 2MZ | 2% 2MZ |
| Developing time (second) | 60 | 60 | 180 | 60 | 60 | 60 | 60 |
| Patterning properties | ○ | ○ | ○ | ○ | ○ | ○ | ○ |
| Resistance to soldering heat | ○ | ○ | ○ | ○ | ○ | ○ | ○ |
| Resistance to solvent | ○ | ○ | ○ | ○ | ○ | ○ | ○ |
| Insulating properties | ≥ 10¹³ Ω | ≥ 10¹³ Ω | ≥ 10¹³ Ω | ≥ 10¹³ Ω | ≥ 10¹³ Ω | ≥ 10¹³ Ω | ≥ 10¹³ Ω |
| Over-drying test | ○ | ○ | ○ | ○ | ○ | ○ | ○ |
| Useful life test | ○ | ○ | ○ | ○ | ○ | ○ | ○ |

**[Table 3]**

| | Comparative Example No. | | | | | | |
|---|---|---|---|---|---|---|---|
| | 1 | 2 | 3 | 4 | 5 | 6 | 7 |
| Curable composition | No. 1 | Com. No. 1 | Com. No. 2 | No. 1 | No. 1 | No. 1 | No. 1 |
| Developing solution | R | R | R | C | D | E | F |
| | 1% Na₂CO₃ | 1% Na₂CO₃ | 1% Na₂CO₃ | 5% DICY | 10% Pyridine | 1% Morpholine | 1% TEA |
| Developing time (second) | 60 | 60 | 180 | 180 | 180 | 60 | 60 |
| Patterning properties | ○ | ○ | × | × | × | ○ | ○ |
| Resistance to soldering heat | × | ○ | - | - | - | × | × |
| Resistance to solvent | × | ○ | - | - | - | × | × |
| Insulating properties | - | ≥ 10¹³ Ω | - | - | - | - | - |
| Over-drying test | ○ | × | × | - | - | ○ | ○ |
| Useful life test | ○ | × | × | - | - | ○ | ○ |

As being clear from the results shown in Table 2 mentioned above, in Examples 1 to 7 in which an alkaline developable photocurable and thermosetting composition containing no curing catalyst was used according to the present invention and the development was carried out by the use of a developing solution containing a curing catalyst of a nitrogen-containing heterocyclic compound, the compositions exhibited long useful life after preparation thereof and excellent patterning properties by development even in the case of over-drying, and the resultant cured film excelled in such properties as resistance to soldering heat, resistance to solvent, and electrical insulating properties. In contrast, in Comparative Examples 4 and 5 which used a developing solution containing dicyandiamide or pyridine, the compositions were deficient in patterning properties by development. On the other hand, in Comparative Examples 1, 6 and 7 which used a developing solution containing sodium carbonate, morpholine or TEA, the cured films were deficient in such properties as resistance to soldering heat and resistance to solvent. Further, in Comparative Examples 2 and 3 which used the photocurable and thermosetting composition containing a curing catalyst, the compositions exhibited short useful life after preparation thereof and inferior patterning properties by development in the case of over-drying.

### <Preparation of Photocurable and Thermosetting Compositions>

### Compositions 5 to 9:

The compositions 5 to 9 were prepared by compounding and stirring the components accounting for varying ratios of combination shown in Table 4 and kneading them with a three-roll mill for dispersion, respectively.

**[Table 4]**

| Components (parts by weight) | | Composition No. | | | | |
|---|---|---|---|---|---|---|
| | | 5 | 6 | 7 | 8 | 9 |
| Resin varnish R-1 (NV: 65%) | | 154.0 | - | - | 154.0 | 154.0 |
| Photosensitive resin *¹ | | - | 256.0 | - | - | - |
| Polycarboxylic resin *² | | - | - | 181.8 | - | - |
| Acrylate monomer *³ | | 25.0 | 25.0 | 25.0 | 25.0 | 25.0 |
| Epoxy resin varnish *⁴ | | 50.0 | 30.0 | 56.0 | 50.0 | 50.0 |
| Epoxy resin *⁵ | | - | - | - | - | - |
| Photopolymerization initiator *⁶ | | 15.0 | 15.0 | 15.0 | 15.0 | 15.0 |
| Oxetane resin A *⁷ | | 20.0 | 20.0 | 20.0 | - | - |
| Oxetane resin B *⁸ | | - | - | - | 7.0 | - |
| Oxetane resin C *⁹ | | - | - | - | - | 15.0 |
| Plasticizer A *¹⁰ | | - | - | - | - | - |
| Plasticizer B *¹¹ | | - | - | - | - | - |
| Phthalocyanine green | | 0.2 | 0.2 | 0.2 | 0.2 | 0.2 |
| Barium sulfate | | 100.0 | 100.0 | 100.0 | 100.0 | 100.0 |
| Talc | | 20.0 | 20.0 | 20.0 | 20.0 | 20.0 |
| Silicone-based anti-foaming agent *¹² | | 1.0 | 1.0 | 1.0 | 1.0 | 1.0 |
| Solvent *¹³ | | 2.0 | 2.0 | 2.0 | 2.0 | 2.0 |
| Total | | 387.2 | 469.2 | 421.0 | 374.2 | 382.2 |
| Remarks | *¹ : Cyclomer (ACA) Z320 manufactured by Daicel Chemical Industries Ltd. | | | | | |
| | *² : Vanaresin PSY-3044 (nonvolatile content: 55 wt.%) manufactured by Shin-Nakamura Chemical Co., Ltd. | | | | | |
| | *³ : ARONIX M6200 manufactured by TOAGOSEI CO., LTD. | | | | | |
| | *⁴ : Varnish of JER 1001 manufactured by Japan Epoxy Resin K.K. diluted with carbitol acetate (nonvolatile content: 75 wt.%) | | | | | |
| | *⁵ : JER 828 manufactured by Japan Epoxy Resin K.K. | | | | | |
| | *⁶ : Irgacure 907 manufactured by Ciba Specialty Chemicals K.K. | | | | | |
| | *⁷ : Aron Oxetane (registered trademark) OXT-121 manufactured by TOAGOSEI CO., LTD. | | | | | |
| | *⁸ : Aron Oxetane OXT-221 manufactured by TOAGOSEI CO., LTD. | | | | | |
| | *⁹ : Aron Oxetane OXT-212 manufactured by TOAGOSEI CO., LTD. | | | | | |
| | *¹⁰ : HA-5 manufactured by Kao Corporation (adipic acid-based polyester) | | | | | |
| | *¹¹ : TRIMEX T-08 manufactured by Kao Corporation (tri-2-ethylhexyl trimellitate) | | | | | |
| | *¹² : KS-66 manufactured by Shin-Etsu Silicone Co., Ltd. | | | | | |
| | *¹³ : Dipropylene glycol monomethylether acetate | | | | | |

### Comparative Compositions 3 to 6:

The comparative compositions 3 to 6 containing no oxetane resin and containing a plasticizer were prepared by compounding and stirring the components accounting for varying ratios of combination shown in Table 5 and kneading them with a three-roll mill for dispersion, respectively.

**[Table 5]**

| Components (parts by weight) | | Comparative Composition No. | | | |
|---|---|---|---|---|---|
| | | 3 | 4 | 5 | 6 |
| Resin varnish R-1 (NV: 65%) | | 154.0 | 154.0 | 154.0 | 154.0 |
| Photosensitive resin *¹ | | - | - | - | - |
| Polycarboxylic resin *² | | - | - | - | - |
| Acrylate monomer *³ | | 25.0 | 25.0 | 25.0 | 25.0 |
| Epoxy resin varnish *⁴ | | 50.0 | 50.0 | 50.0 | 50.0 |
| Epoxy resin *⁵ | | - | - | 20.0 | 20.0 |
| Photopolymerization initiator *⁶ | | 15.0 | 15.0 | 15.0 | 15.0 |
| Oxetane resin A *⁷ | | - | - | - | - |
| Oxetane resin B *⁸ | | - | - | - | - |
| Oxetane resin C *⁹ | | - | - | - | - |
| lasticizer A *¹⁰ | | 7.0 | - | 7.0 | - |
| Plasticizer B *¹¹ | | - | 7.0 | - | 7.0 |
| Phthalocyanine green | | 0.2 | 0.2 | 0.2 | 0.2 |
| Barium sulfate | | 100.0 | 100.0 | 100.0 | 100.0 |
| Talc | | 20.0 | 20.0 | 20.0 | 20.0 |
| Silicone-based anti-foaming agent *¹² | | 1.0 | 1.0 | 1.0 | 1.0 |
| Solvent *¹³ | | 2.0 | 2.0 | 2.0 | 2.0 |
| Total | | 374.2 | 374.2 | 394.2 | 394.2 |
| Remarks | *¹ : Cyclomer (ACA) Z320 manufactured by Daicel Chemical Industries Ltd. | | | | |
| | *² : Vanaresin PSY-3044 (nonvolatile content: 55 wt.%)manufactured by Shin-Nakamura Chemical Co., Ltd. | | | | |
| | *³ : ARONIX M6200 manufactured by TOAGOSEI CO., LTD. | | | | |
| | *⁴ : Varnish of JER 1001 manufactured by Japan Epoxy Resin K.K. diluted with carbitol acetate (nonvolatile content: 75 wt.%) | | | | |
| | *⁵ : JER 828 manufactured by Japan Epoxy Resin K.K. | | | | |
| | *⁶ : Irgacure 907 manufactured by Ciba Specialty Chemicals K.K. | | | | |
| | *⁷ : Aron Oxetane OXT-121 manufactured by TOAGOSEI CO., LTD. | | | | |
| | *⁸ : Aron Oxetane OXT-221 manufactured by TOAGOSEI CO., LTD. | | | | |
| | *⁹ : Aron Oxetane OXT-212 manufactured by TOAGOSEI CO., LTD. | | | | |
| | *¹⁰ : HA-5 manufactured by Kao Corporation (adipic acid-based polyester) | | | | |
| | *¹¹ : TRIMEX T-08 manufactured by Kao Corporation (tri-2-ethylhexyl trimellitate) | | | | |
| | *¹² : KS-66 manufactured by Shin-Etsu Silicone Co., Ltd. | | | | |
| | *¹³ : Dipropylene glycol monomethylether acetate | | | | |

### <Preparation of test substrates>

Each of the compositions shown in Table 4 and Table 5 mentioned above was applied by screen printing to the entire surface of a printed circuit board having a circuit formed in advance thereon to form a coating film of about 30 µm thickness and then dried at 80°C for 30 minutes by heating. Thereafter, the coating film on the board was exposed to light through a negative film under the conditions of accumulated irradiation dose of 400 mJ/cm². Then, the coating film was developed for 60 seconds with respective developing solutions and further thermally cured at 150°C for 60 minutes to prepare a test substrate. Each test substrate was subjected to the following tests.

### <Adhesiveness test>

The cured film of each test substrate having 11 cross-cuts in the longitudinal direction and 11 cross-cuts in the transverse direction incised therein at intervals of 1 mm with a cutting knife was subjected to a peel test with a cellophane adhesive tape to visually examine the degree of fragmentation at the cut (the powdered state caused by fragmentation). The criterion for evaluation is as follows. The degree of fragmentation becomes large in proportion to the hardness and brittleness of the cured film.
○: No discernible fragmentation at the cut was observed.
△: Slight fragmentation was observed in cross portions of cut.
×: Fragmentation was observed not only in cross portions of cut but also in cut lines.

### <Bleedout test>

Each test substrate was heated to 200°C for 3 minutes in a drying oven and extracted therefrom. After the test substrate was left standing until it had the same temperature as room temperature, the surface state of the cured film was examined by finger touch.
○: No discernible change in the surface of the cured film was observed.
△: Slight bleeding in the surface of the cured film was observed.
×: Bleeding in the surface of the cured film was observed.

### <Pencil hardness test>

In accordance with the testing method of JIS (Japanese Industrial Standard) K5400 using a pencil hardness tester, a given test substrate was placed under a load of 1 kg. This property was reported by the highest hardness which inflicted no dent on the film. The pencils used for this test were "Mitsubishi Hi-Uni" (manufactured by Mitsubishi Pencil Co., Ltd).

### <Resistance to soldering heat>

Each test substrate was coated with a rosin-based flux and floated in a solder bath set in advance at 260°C for 30 seconds, and visually examined as to swelling and exfoliation of the cured film.
○: No discernable swelling or exfoliation of the cured film was observed.
△: Slight swelling or exfoliation of the cured film was observed.
×: Swelling or exfoliation of the cured film was observed.

### <Test for resistance to chemicals>

Each test substrate was immersed in propylene glycol monomethyl ether acetate for 30 minutes. After the test substrate was left standing and dried, the cured film was subjected to a peel test with a cellophane adhesive tape and visually examined the presence or absence of exfoliation of the cured film. The criterion for evaluation is as follows:
○: No exfoliation of the cured film was observed.
△: Slight exfoliation of the cured film was observed.
×: Exfoliation of the cured film was observed.

### <Insulating properties>

A cured film was prepared in the same manner as the preparation of the test substrates mentioned above by the use of a comb electrode B coupon of IPC B-25. Each test substrate was tested for insulating resistance by application of a bias voltage of DC 500V to the comb electrode.

The results of tests mentioned above are shown in Table 6 and Table 7.

**[Table 6]**

| | Example No. | | | | | | |
|---|---|---|---|---|---|---|---|
| | 8 | 9 | 10 | 11 | 12 | 13 | 14 |
| Composition No. | 5 | 6 | 5 | 6 | 7 | 8 | 9 |
| Developing solution | A | A | B-2 | B-2 | B-2 | B-2 | B-2 |
| Adhesiveness | ○ | ○ | ○ | ○ | ○ | ○ | ○ |
| Bleedout test | ○ | ○ | ○ | ○ | ○ | ○ | ○ |
| Pencil hardness test | 6H | 6H | 6H | 6H | 5H | 6H | 6H |
| Resistance to soldering heat | ○ | ○ | ○ | ○ | ○ | ○ | ○ |
| Resistance to chemicals | ○ | ○ | ○ | ○ | ○ | ○ | ○ |
| Insulating resistance | ≥ 10¹³ Ω | ≥ 10¹³ Ω | ≥ 10¹³ Ω | ≥ 10¹³ Ω | ≥ 10¹³ Ω | ≥ 10¹³ Ω | ≥ 10¹³ Ω |

**[Table 7]**

| | Comparative Example No. | | | |
|---|---|---|---|---|
| | 8 | 9 | 10 | 11 |
| Comparative composition No. | 3 | 4 | 5 | 6 |
| Developing solution | B-2 | B-2 | B-2 | B-2 |
| Adhesiveness | ○ | ○ | ○ | ○ |
| Bleedout test | × | × | × | × |
| Pencil hardness test | 4H | 4H | 4H | 4H |
| Resistance to soldering heat | × | × | △ | △ |
| Resistance to chemicals | △ | △ | △ | △ |
| Insulating resistance | ≥ 10¹³ Ω | ≥ 10¹³ Ω | ≥ 10¹³ Ω | ≥ 10¹³ Ω |

As being clear from the results shown in Table 6 and Table 7 mentioned above, in Examples 8 to 14 in which an alkaline developable photocurable and thermosetting composition containing no thermal curing catalyst was used according to the present invention and the development was carried out by the use of a developing solution containing a basic curing catalyst of a nitrogen-containing heterocyclic compound, the resultant cured film excelled in such properties as adhesiveness, pencil hardness, resistance to soldering heat, resistance to chemicals (resistance to solvent), and electrical insulating properties. In contrast, in Comparative Examples 8 to 11 using the compositions which were formulated so as to contain no oxetane resin and contain a plasticizer added thereto so that the cured film becomes soft, the cured film were deficient in such properties as resistance to bleedout, resistance to soldering heat and resistance to chemicals (resistance to solvent) though the adhesiveness was improved.

### Industrial Applicability

The aforementioned composition for forming a cured film pattern and the method of producing a cured film pattern by the use thereof according to the present invention are useful for the formation of a solder resist, an etching resist, and a plating resist for printed circuit boards, an interlaminar insulating layer for a multi-layer circuit board, a permanent mask to be used in the manufacture of tape carrier bags, a resist for flexible circuit boards, a resist for color filters, a resist for ink-jet printing, or the like. Further, they may be used in the formation of an adhesive layer for bonding semiconductor parts such as semiconductor elements to various boards such as flexible boards, rigid boards, lead frames, or insulating boards.

## Claims

1. A composition for forming a cured film pattern, **characterized by** comprising a combination of:
an alkaline developable photocurable and thermosetting composition containing no thermal curing catalyst, which is used for forming a cured film pattern by subjecting a film formed on a substrate to exposure to light, development for removing an unexposed area, and thermal curing; and
a developing solution comprising an aqueous solution of a basic curing catalyst of a nitrogen-containing heterocyclic compound for promoting a thermosetting reaction.

2. The composition for forming a cured film pattern set forth in claim 1, **characterized in that** said photocurable and thermosetting composition comprises as essential components:
(A) a carboxylic group-containing photosensitive compound (A-1), or a carboxylic group-containing compound (A-2) and a compound containing an ethylenically unsaturated double bond (A-3),
(B) a photopolymerization initiator, and
(C) a thermosetting resin.

3. A composition for forming a cured film pattern, **characterized by** comprising a combination of:
a photocurable and thermosetting composition containing no thermal curing catalyst, which comprises as essential components:
(A) a carboxylic group-containing photosensitive compound (A-1), or a carboxylic group-containing compound (A-2) and a compound containing an ethylenically unsaturated double bond (A-3),
(B) a photopolymerization initiator,
(C-1) an epoxy resin, and
(C-2) an oxetane compound; and
a developing solution comprising an aqueous solution of a basic curing catalyst of a nitrogen-containing heterocyclic compound for promoting a thermosetting reaction.

4. The composition for forming a cured film pattern set forth in any one of claims 1 to 3, **characterized in that** said photocurable and thermosetting composition is in the form of liquid or a dry film.

5. The developing solution set forth in any one of claims 1 to 4, **characterized in that** said basic curing catalyst is a heterocyclic compound having an amidine structure.

6. The developing solution set forth in claim 5, **characterized in that** said heterocyclic compound having an amidine structure is at least one compound selected from the group consisting of 1,8-diazabicyclo[5.4.0]undeca-7-ene, 1,5-diazabicyclo[4.3.0]nona-5-ene, 1,4-diazabicyclo[2.2.2]octane, derivative salts thereof, and an imidazole compound.

7. The developing solution set forth in any one of claims 1 to 4, **characterized in that** said basic curing catalyst is an imidazole compound.

8. The developing solution set forth in any one of claims 1 to 4, **characterized in that** said basic curing catalyst is 2-methylimidazole.

9. A method of producing a cured film pattern, **characterized by** comprising:
preparing the composition for forming a cured film pattern set forth in any one of claims 1 to 8 for use,
selectively exposing a film of said photocurable and thermosetting composition containing no thermal curing catalyst to an actinic energy ray;
developing the film with said developing solution comprising an aqueous solution of a basic curing catalyst of a nitrogen-containing heterocyclic compound for promoting a thermosetting reaction, thereby removing an unexposed area of the film and doping an exposed area of the film with said basic curing catalyst, and then
thermally curing the film to form a cured film pattern.
